# EUROPEAN PATENT SPECIFICATION

(11) **EP 2 381 477 B1**
(45) Date of publication and mention of the grant of the patent: **13.08.2014**
(21) Application number: 11162970.5
(22) Date of filing: 19.04.2011
(51) Int. Cl.: H01L 27/142, H01L 31/18

(54) **Method for increasing the working surface area of a photovoltaic module**
Verfahren zur Erhöhung der wirksamen Oberfläche auf einem Photovoltaikomodul
Procédé d'augmentation de l'aire de surface effective d'un module photovoltaïque

(30) Priority: 22.04.2010 US 765340
(43) Date of publication of application: 26.10.2011
(73) Proprietor: First Solar Malaysia SDN.BHD, Aman (MY)
(72) Inventor: LITTLE, Edwin Jackson, Arvada, CO 80004 (US); REED, Max William, Arvada, CO 80004 (US); PAULMAN, Jason Scott, Arvada, CO 80004 (US)
(74) Representative: Thurston, Joanna

(56) References cited:
- EP-A2- 1 005 096
- EP-A2- 2 075 851
- JP-A- 2009 295 943
- JP-A- 2009 297 742

## Description

The subject matter disclosed herein relates generally to photovoltaic (PV) modules, and more particularly to a method for increasing the working surface area of such modules.

Thin film photovoltaic (PV) modules (also referred to as "solar panels") are gaining wide acceptance and interest in the industry. As is well known, these modules are formed by sandwiching certain types of semiconductor materials between electrode materials. Cadmium telluride (CdTe) paired with cadmium sulfide (CdS) as the photo-reactive components are particularly good materials. CdTe is a semiconductor material having characteristics particularly suited for conversion of solar energy (sunlight) to electricity. For example, CdTe has an energy bandgap of 1.45 eV, which enables it to convert more energy from the solar spectrum as compared to lower bandgap (1.1eV) semiconductor materials historically used in solar cell applications. Also, CdTe converts energy in lower or diffuse light conditions as compared to the lower bandgap materials and, thus, has a longer effective conversion time over the course of a day or in low-light (e.g., cloudy) conditions as compared to other conventional materials.

The PV modules are conventionally formed by deposition of the various semiconductor materials and electrode layers as thin film layers (generally recognized in the art as less than 10 microns (µm)) on a glass substrate. The substrate then undergoes various processing steps, including laser scribing processes, to define and isolate individual cells, define a perimeter edge zone around the cells, connect the cells in series, and so forth. These steps result in a plurality of individual solar cells defined within the physical edges of the substrate, and in less than all of the original surface area of the substrate being utilized. A laser scribing process to define and isolate individual solar cells is known from JP 2009297742.

The advantages of CdTe not withstanding, sustainable commercial exploitation and acceptance of solar power as a supplemental or primary source of industrial or residential power depends on the ability to produce efficient PV modules on a large scale and in a cost effective manner to reduce the overall cost per unit of power generated. Certain factors greatly affect the efficiency of the PV modules in this regard. For example, CdTe is relatively expensive and, thus, efficient utilization (i.e., minimal waste) of the material is a primary cost factor, particularly in the final processing steps of defining the individual cells on the substrate. In addition, efficient utilization of the working surface area of the module results in an increased power generation capacity for the module.

Accordingly, there exists an ongoing need in the industry for improved processing steps that reduce the waste of expensive materials and increase the power generation capacity of PV modules. The present invention serves this purpose.

Various aspects and advantages of the invention will be set forth in part in the following description, or may be clear from the description, or may be learned through practice of the invention.

A method is provided for processing substrates in the formation of photovoltaic (PV) modules, the substrates having a plurality of thin film layers deposited thereon. The method as set out in claim 1 includes determining the geometric center of the substrate and performing subsequent processing steps for defining individual cells on the substrate using the geometric center as a starting reference point for such processing steps.

The subsequent processing steps include laser scribing a pattern of lines in the thin film layers on the substrate to define the individual cells. A location for an initial one of the pattern of lines is set at a defined distance from the geometric center of the substrate. A longitudinal axis of the substrate is defined through the geometric center of the substrate and the pattern of lines is defined at a perpendicular to the longitudinal axis.

In an embodiment, an additional subsequent processing step may define an isolation border, such as a rectangular laser scribed border, on the substrate around the individual cells using the geometric center of the substrate as a starting reference point for the border. The sides of the rectangular border are at a defined distance from the geometric center of the substrate, and the border may have a geometric center that is coincident with the geometric center of the substrate.

Another subsequent processing step may include defining an edge delete zone outward of the isolation border on the substrate using the geometric center of the substrate as a starting reference point such that the edge delete zone has sides that are located at a defined distance from the geometric center of the substrate, and may have a geometric center that is coincident with the geometric center of the substrate.

Variations and modifications to the methods discussed above are within the scope of the invention which is defined by the claims and may be further described herein.

Substrates or completed PV modules having certain of the characteristics discussed above are obtained. For example, such a substrate has a geometric center and a laser scribed pattern of lines in the thin film layers thereof that define individual cells on the substrate. The pattern of lines is perpendicular to a longitudinal centerline of the substrate and is centered on the geometric center such that the pattern of lines extends in opposite longitudinal directions referenced from the geometric center. A laser scribed rectangular isolation border is defined in the thin film layers around the pattern of lines, with the isolation border defining transverse ends of the individual cells and an outer line of the first and last longitudinal ones of the cells. This rectangular isolation border has a geometric center that is coincident with the geometric center of the substrate. An edge delete zone is defined around the isolation border, and may also be centered on the geometric center of the substrate.

These and other features, aspects and advantages of the present invention will become better understood with reference to the following description and appended claims. In the drawings:
Fig. 1 is a top partial cut-away view of a PV module substrate illustrating a plurality of thin film layers thereon and a geometric center;
Fig. 2 is a top view of the substrate of Fig. 1 with an initial laser scribe pattern that defines individual cells;
Fig. 3 is a top view of the substrate of Fig. 2 with an isolation laser scribe;
Fig. 4 is a top view of the substrate of Fig. 3 with an edge delete zone defined thereon; and,
Fig. 5 is a top diagrammatic view of a substrate indicating various tolerances of the laser scribed regions, edge delete regions, and glass size/shape tolerance regions.

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope of the invention. For instance, features illustrated or described as part of one embodiment can be used with other embodiments to yield still further embodiments. Thus, it is intended that the present invention encompass such modifications and variations as come within the scope of the appended claims and their equivalents.

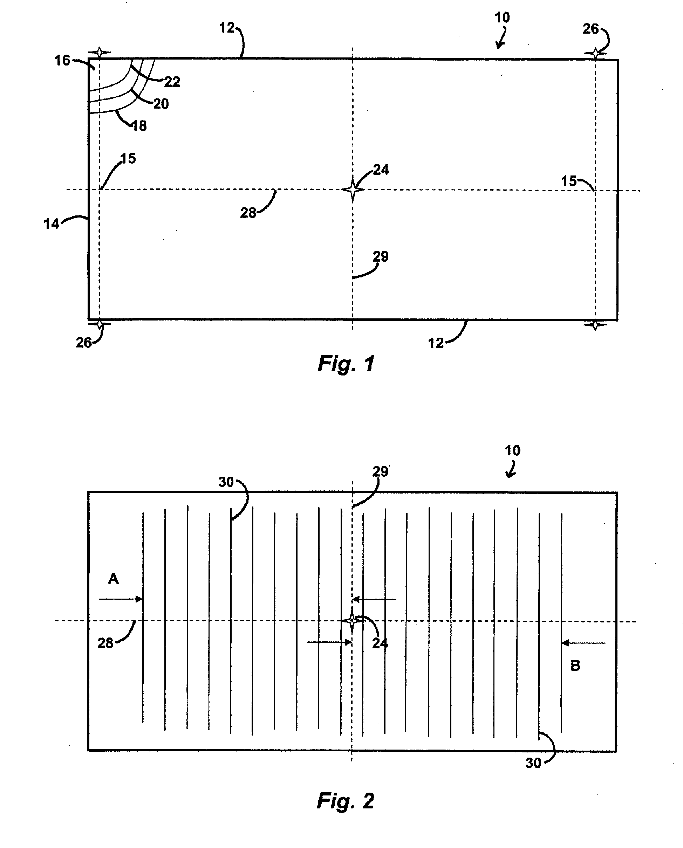

Fig. 1 illustrates a substrate 10 that is used in the manufacture of a photovoltaic (PV) module. The substrate 10 includes a glass sheet 16 having a plurality of thin film layers deposited thereon. It should be appreciated that the present invention is not limited by any particular type of substrate 10 or thin film layers. A typical CdTe PV module may include multiple thin film layers deposited on the glass 16 before deposition of the CdTe layer. For example, the glass sheet 16 may be provided with a transparent conductive oxide (TCO) layer formed thereon, or the TCO layer may be deposited in a subsequent deposition process. A resistive transparent buffer (RTB) layer 22 is then applied on the TCO layer. The RTB layer may be a zinc-tin oxide (ZTO) layer and may be referred to as a "ZTO layer." A cadmium sulfide (CdS) layer 20 is applied on the RTB layer. These various layers may be applied in a conventional sputtering deposition process that involves ejecting material from a target (i.e., the material source), and depositing the ejected material onto the substrate to form the film. The CdTe layer 18 is deposited on the CdS layer by a suitable deposition process, such as a close-space sublimation (CSS) process.

Once all of the various thin film layers have been deposited on the glass 16, the substrate 10 must be further processed in order to define the various cells, edge zones, and so forth. This typically involves various laser scribing steps, among other processes. As discussed, various aspects the present invention aim to control these further processing steps to increase the surface area of the substrate 10 that is used in the live cells so as to increase the power generation capacity of the substrate 10.

Referring to Fig. 1, a geometric center 24 of the substrate 10, particularly the glass sheet 16, is first determined. This center 24 may be determined by any number of techniques. In a particular embodiment, the geometric center 24 is determined by placement of a first pair of points 26 on the longitudinal sides 12 of the glass sheet 16 adjacent to one of the transverse ends 14. A second pair of points 26 is located on the longitudinal sides 12 adjacent to the opposite transverse end 14 of the glass sheet 16, as illustrated in Fig. 1. These pairs of points 26 may be defined at the same set-back distance from the midpoints of transverse ends 14 of the sheet 16, or at different symmetric distances. An imaginary line is defined between the respective pairs of points (as indicated in Fig. 1) and the center points 15 of these lines are then determined. An imaginary line is defined between the center points of these lines and is established as the center longitudinal axis 28 of the sheet 16, as illustrated in Fig. 1. After extending the longitudinal axis 28 to the transverse ends 14 of the glass sheet 16, the midpoint (edge-to-edge) of the longitudinal axis 28 is then determined and a perpendicular line is drawn through this midpoint and is defined as the transverse centerline 29. The intersection of the lines 28 and 29 is defined as the geometric center 24.

It should be appreciated that the lines 28 and 29, connection lines between the edge marks 26, and the edge marks 26 are not physically defined on the glass sheet 16, but are empirically determined and stored in the appropriate laser scribing equipment in which the substrate 10 is received.

Once the geometric center 24 of the glass sheet 16 has been established, the subsequent processing steps are carried out for defining individual cells on the substrate 10 using the geometric center 24 as a starting reference point for the respective processing steps.

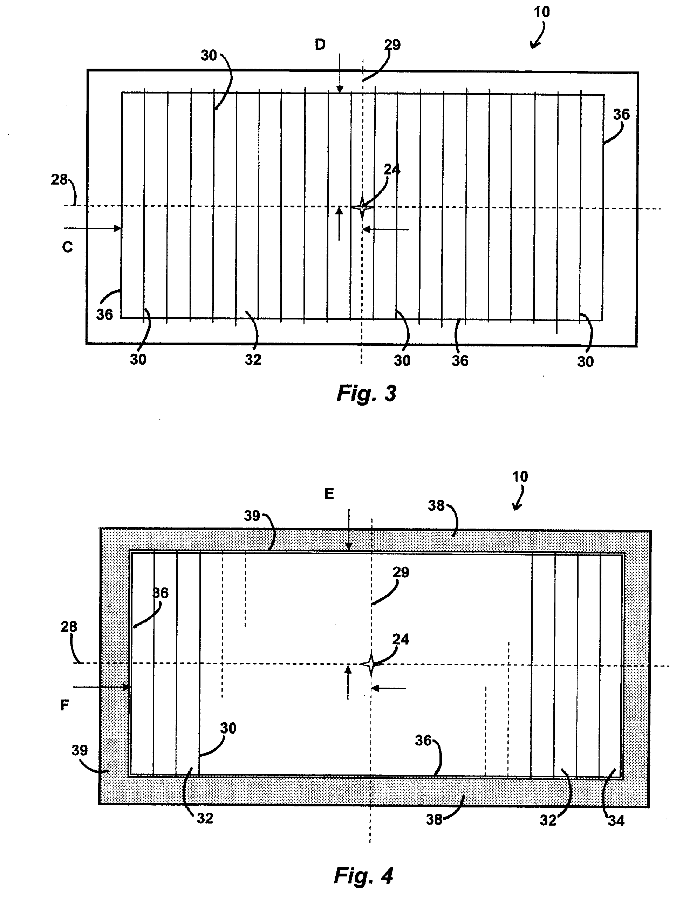

For example, referring to Fig. 2, an initial subsequent processing step involves laser scribing a plurality of lines 30 that define the longitudinal sides of individual cells 32 (Fig. 3). Each of the lines 30 may actually be a plurality of individual scribed lines at each location to isolate and define the various conductive layers of the individual cells 32. The plurality of lines 30 may be thought of as a "pattern" of adjacent and parallel lines, with the pattern having extreme opposite lines, as depicted in Fig. 2. For initial placement and locating of the pattern of lines 30 relative to the substrate 10, a distance A or B of the extreme end lines 30 from the geometric center 24 of the substrate 10 is predefined, with these distances dictating the relative position of either one of the extreme end lines 30 along the longitudinal axis 28 with respect to the geometric center 24. Depending on the processing direction of the substrate 10 through the laser scribing equipment, either one of the extreme end lines 30 is scribed first with the other lines being subsequently scribed at a defined distance from the adjacent line 30. The lines 30 are laser scribed perpendicular to the longitudinal centerline 28 and are thus essentially parallel to the transverse centerline 29.

Thus, it should be readily appreciated that the relative location of the pattern of lines 30 is initially dependent on the defined setback distance A or B (which distances may or may not be the same) from the geometric center 24 of the substrate 10. In other words, the end lines 30 are not defined at a distance from the transverse ends 14 of the substrate 10, but from the geometric center 24 of the substrate 10.

As illustrated in Fig. 2, the longitudinal length of the individual cell lines 30 may vary. The length of these lines need not be precisely controlled in view of further processing steps that will isolate and define the transverse ends of the individual cells.

Referring to Fig. 3, in a subsequent processing step, an isolation border 36 is defined on the substrate 10 in a laser scribing process that cuts through all of the thin film layers. This laser scribed isolation border 36 is thus a rectangular border that defines the longitudinal ends of the individual cells 32, as well as the outer defining longitudinal lines of the extreme outer cells 32, as depicted in Fig. 3. This rectangular border 36 is also defined as a function of the geometric center 24. For example, the geometric center of the rectangular isolation border 36 may be coincident with the geometric center 24 of the substrate 10, or the sides of the border 36 may be defined at predefined distances from the geometric center 24. Referring to Fig. 3, the transverse side of the border 36 is set at a defined distance C from the geometric center 24. Likewise, the longitudinal sides of the border 36 that cut across the lines 30 are located at a predefined distance D from geometric center 24. These predefined distances C and D may be the midpoints of their respective sides such that the geometric center of the border coincides with the geometric center 24 of the substrate. Thus, initial placement of the longitudinal and transverse lines of the border 36 is dependent on the geometric center 24 of the substrate. The lines are not set back from the edges of the glass sheet 16.

Fig. 4 represents an additional subsequent processing step wherein an edge delete zone 38 is defined outward of the isolation border scribe 36. This process typically involves an ablation process wherein blasting jets remove the thin film layers from the glass sheet 16 in the edge delete zone 38. The edge delete zone 38 is defined by an inner rectangular border 39 and extends to the edges of the glass sheet 16. As with the isolation scribe lines 36, the edge delete border 39 is a rectangular border having its sides defined at predefined distances from the geometric center 24 of the substrate 10 and, in this regard, may have its center coincident with the geometric center 24. The lines 39 at the transverse ends of the border are defined at a distance F from the geometric center 24. The distance F may be the known midpoint of the length dimension of the border 39. Likewise, the longitudinal sides 39 of the border are at a defined distance E from the geometric center 24, which may be the midpoint of the transverse aspect of the border 39. The lines 39 defining the inward edge of the edge delete zone 38 may coincide with the isolation scribes 38 or may be at a small setback distance from the isolation scribe lines 38 to account for tolerances of the processing steps, as depicted in Fig. 4.

In an alternate embodiment of a process in accordance with aspects of the invention, it may be suitable to define the inward boundaries of the edge delete zone 38 by initially setting the lines 39 at defined distances from the edges 12, 14 of the glass sheet 16. In other words, in this embodiment, the edge delete zone 38, particularly the defining lines 39 thereof, are not necessarily dependent on the geometric center 24 of the substrate 10.

In yet another embodiment, the transverse centerline 29 may be defined as the average profile of the transverse ends (edges) the glass sheet 16, which may not be ninety degrees to the longitudinal centerline 28. The edge delete border 39 on the transverse ends may then be oriented parallel to this modified transverse centerline, with the same centering aspects as stated above for the longitudinal borders relative to the longitudinal centerline 28.

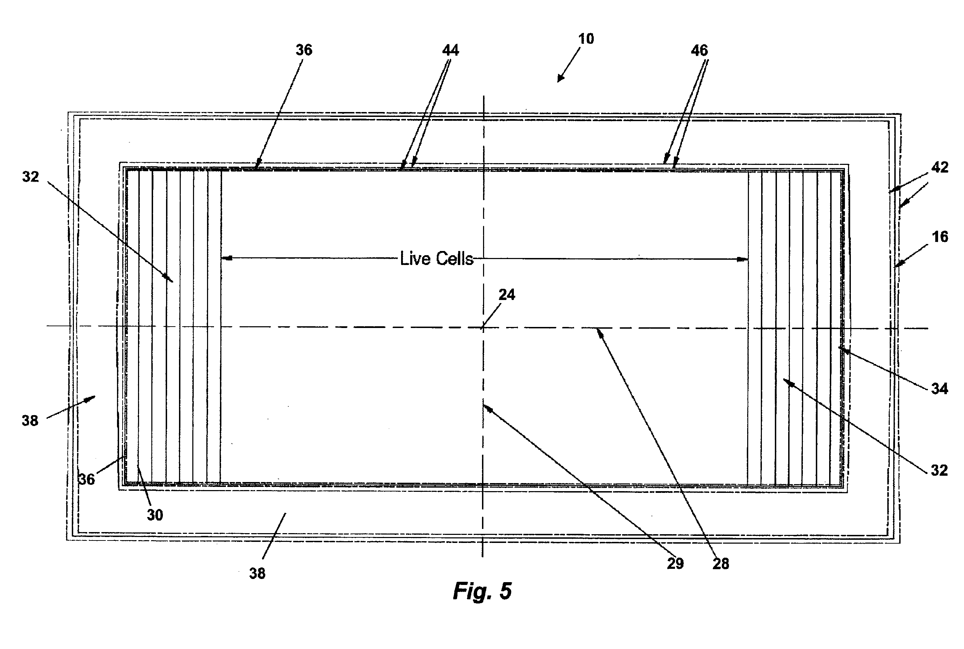

Fig. 5 is a depiction of the substrate 10 after the various processing steps discussed above and illustrates particular concepts of the invention. For example, the initial glass sheet 16 is generally not perfectly dimensioned, and a tolerance zone 42 is to be expected. Generally, the length and width of the glass may vary between about ± 0.8 mm. The squareness of the glass is defined by the difference in diagonal measurements, which typically may vary within about 2 mm. Thus, the glass may have a parallelogram or trapezoid shape as long as it is within acceptable specifications for length, width, and squareness. The imperfections in the glass sheet 16 as depicted by the tolerance zone 42 in Fig. 5 are thus taken into consideration in the present processes.

Still referring to Fig. 5, the laser scribe lines defining the isolation border 36 are also defined within a tolerance zone 44. As described above, the isolation scribe lines 36 define the transverse ends of the live cells 32. In addition, the extreme longitudinal sides of the first and last cells are defined by the isolation scribe 36. In certain embodiments, one of the extreme end cells may be a "dead" cell 34, as depicted in Fig. 4, which may be smaller (narrower) than the live cells 32. Thus, by defining the pattern of cells lines 30 dependent on the geometric center 24 of the substrate 10, as well as the isolation scribe lines 36, it is ensured that the first live cell 32 has the proper size. The tolerances of the respective scribe lines (i.e., tolerance zone 44) is not compounded with the tolerance zone 42 of the glass sheet, which could result in a significantly reduced first live cell 32 or dead cell 34.

Still referring to Fig. 5, the edge delete zone 38 must have a specified dimension for subsequent sealing purposes. For example, this dimension may be at least about 9.5 mm. The edge delete zone 38 also has a tolerance zone 46 that is accounted for by centering the geometric center of the edge delete zone 38 coincident with the geometric center 24 of the substrate 10, as discussed above.

It should thus be appreciated from Fig. 5 that the various imperfections as reflected by the tolerance zones 42, 44, 46 do not become cumulative or additive in the processes described herein wherein the various scribe patterns are dependent (or even centered) on the geometric center 24 of the substrate 10, which could result if the various scribe patterns and processes were initially referenced to an edge or corner of the substrate 10, particularly the initial glass sheet 16.

A substrate 10 for use in the manufacture of PV modules having the characteristics described above is obtained. For example, the substrate 10 has a geometric center 24 and a pattern of laser scribed lines 30 that define individual cells 32 on the substrate 10. The scribe lines 30 are perpendicular to a longitudinal centerline 28 of the substrate 10 and are set at a predefined distance from, or centered on, the geometric center 24 such that the pattern of lines 30 extends in opposite longitudinal directions from the geometric center 24, as illustrated in Figs. 2 and 3. A substrate 10 may also include a laser scribed rectangular isolation border 36 defined through the thin film layers around the pattern of lines 30, with the isolation border 36 defining the transverse ends of the cells 32 and the outer defining lines of the first and last longitudinal ones of the cells 32, as particularly illustrated in Fig. 3. The rectangular isolation border 36 has sides that are located at defined distances from the geometric center 24, and may have a center that is coincident with the geometric center 24 of the substrate.

The substrate 10 may also include an edge delete zone 38 defined as a border zone around the isolation scribe lines 36. In a particular embodiment, the edge delete zone is defined as a rectangular border having sides located at defined distances from the geometric center 24, and may be centered on the geometric center 24 of the substrate 10, as particularly illustrated in Fig. 4.

This written description uses examples to disclose the invention, including the preferred mode, and also to enable any person skilled in the art to practice the invention, including making and using any devices or systems and performing any incorporated methods. The patentable scope of the invention is defined by the claims, and may include other examples that occur to those skilled in the art.

## Claims

1. A method for processing substrates (10) in the formation of photovoltaic (PV) modules, the substrates having a plurality of thin film layers (18,20,22) deposited thereon, said method comprising:
determining the geometric center (24) of the substrate; and
performing subsequent processing steps for defining individual cells (32) on the substrate using the geometric center of the substrate as a starting reference point for such processing steps, wherein the subsequent processing steps include laser scribing a pattern of lines (30) in the thin film layers on the substrate (10) to define the individual cells (32), a location for an initial one of the pattern of lines being set at a defined distance from the geometric center (24) of the substrate, and further comprising defining a longitudinal axis (28) of the substrate through the geometric center of the substrate and defining the pattern of lines (30) at a perpendicular to the longitudinal axis.

2. The method as in claim 1, further comprising performing additional subsequent processing steps to define an isolation border (36) on the substrate (10) around the individual cells (30) using the geometric center (24) of the substrate as a starting reference point for such additional subsequent processing steps.

3. The method as in claim 2, wherein the additional subsequent processing steps include laser scribing a rectangular isolation border (36) that defines the longitudinal ends of the individual cells (30) and an outer line of the first and last ones of the individual cells on the substrate (10), the rectangular isolation border (36) defined by locating the geometric center of the rectangular isolation border coincident with the geometric center of the substrate.

4. The method as in claim 2 or claim 3, further comprising performing further subsequent processing steps to define an edge delete zone (38) outward of the isolation border (36) on the substrate using (10) the geometric center (24) of the substrate as a starting reference point for such further subsequent processing steps.

5. The method as in any of claims 2 to 4, wherein the further subsequent processing steps include defining the edge delete zone (38) as a rectangular border around the isolation border (36) on the substrate (10) by locating the sides of the rectangular border at defined distances from the geometric center of the substrate.

6. The method as in any of claims 2 to 5 further comprising defining an edge delete zone (38) outward of the isolation border (36), the edge delete zone having dimensions that are measured inward from the edges of the substrate.

7. The method as in any preceding claim, wherein the geometric center (24) of the substrate (10) is determined by:
defining a first pair of points (26) on the longitudinal sides (12) of the substrate set back a defined distance from a first longitudinal end (14) of the substrate, and a second pair of points (26) on the longitudinal sides (12) of the substrate set back a defined distance from a second longitudinal end (14) of the substrate (10); and
determining the center of a line drawn between the points in each respective pair of points, and drawing a longitudinal line between the centers to establish a longitudinal centerline (28) of the substrate and extending the longitudinal centerline to the ends of the substrate, the geometric centerline (24) being set at the midpoint of the longitudinal centerline.

## Patentansprüche

1. Verfahren zur Verarbeitung von Substraten (10) bei der Herstellung von Photovoltaik-(PV)-Modulen, wobei die Substrate eine Vielzahl von darauf aufgetragenen Dünnfilmschichten (18,20,22) aufweisen, umfassend:
Bestimmen des geometrischen Zentrums (24) des Substrats; und
Durchführen anschließender Prozessschritte zum Festlegen individueller Zellen (32) auf dem Substrat unter Nutzung des geometrischen Zentrums des Substrats als Anfangsreferenzpunkt für derartige Prozessschritte, wobei die anschließenden Prozessschritte Laserritzen eines Musters von Linien (30) in die Dünnfilmschichten auf dem Substrat (10) zum Festlegen der individuellen Zellen (32) einschließen, wobei ein Ort für eine Startlinie des Musters der Linien in einem definierten Abstand vom geometrischen Zentrum (24) des Substrats gesetzt wird, und des Weiteren umfassend Festlegen einer Longitudinalachse (28) des Substrats durch das geometrische Zentrum des Substrats hindurch und Festlegen des Musters der Linien (30) an einer Senkrechten zur Longitudinalachse.

2. Verfahren nach Anspruch 1, des Weiteren umfassend das Durchführen weiterer anschließender Prozessschritte um einen Isolationsrahmen (36) auf dem Substrat (10) um die individuellen Zellen (30) herum festzulegen, wobei das geometrische Zentrum (24) des Substrats als ein Anfangsreferenzpunkt für derartige zusätzliche anschließende Prozessschritte genutzt wird.

3. Verfahren nach Anspruch 2, wobei die zusätzlichen anschließenden Prozessschritte Laserritzen eines rechteckigen Isolationsrahmens (36) einschließen, welcher die longitudinalen Enden der individuellen Zellen (30) und eine äußere Linie der ersten und der letzten der individuellen Zellen auf dem Substrat (10) festlegt, wobei der rechteckige Isolationsrahmen (36) festgelegt wird, indem das geometrische Zentrum des rechteckigen Isolationsrahmens zusammenfallend mit dem geometrischen Zentrum des Substrats örtlich festgelegt wird.

4. Verfahren nach Anspruch 2 oder 3, des Weiteren umfassend Durchführen weiterer anschließender Prozessschritte um eine Kantenbeseitigungszone (38) außerhalb des Isolationsrahmens (36) auf dem Substrat (10) festzulegen, wobei das geometrische Zentrum (24) des Substrats als ein Anfangsreferenzpunkt für derartige weitere anschließende Prozessschritte genutzt wird.

5. Verfahren nach einem der Ansprüche 2 bis 4, wobei die weiteren anschließenden Prozessschritte es einschließen, die Kantenbeseitigungszone (38) als einen rechteckigen Rahmen um den Isolationsrahmen (36) herum auf dem Substrat (10) festzulegen, indem die Seiten des rechteckigen Rahmens in bestimmten Abständen vom geometrischen Zentrum des Substrats örtlich festgelegt werden.

6. Verfahren nach einem der Ansprüche 2 bis 5, des Weiteren umfassend Festlegen einer Kantenbeseitigungszone (38) außerhalb des Isolationsrahmens (36), wobei die Kantenbeseitigungszone Abmessungen aufweist, welche von den Kanten des Substrats aus nach innen gemessen werden.

7. Verfahren nach einem der vorherigen Ansprüche, wobei das geometrische Zentrum (24) des Substrats (10) bestimmt wird durch:
Festlegen eines um einen bestimmten Abstand von einem ersten longitudinalen Ende (14) des Substrats zurückgesetzten ersten Paars von Punkten (26) auf den longitudinalen Seiten (12) des Substrats und eines um einen bestimmten Abstand von einem zweiten longitudinalen Ende (14) des Substrats zurückgesetzten zweiten Paars von Punkten (26) auf den longitudinalen Seiten (12) des Substrats; und
Bestimmen des Zentrums einer jeweils zwischen den Punkten jedes Punktepaars gezogenen Linie und Ziehen einer longitudinalen Linie zwischen den Zentren, um eine longitudinale Mittellinie (28) auf dem Substrat herzustellen und Ausdehnen der longitudinalen Mittellinie zu den Enden des Substrats, wobei die geometrische Mittellinie (24) am Mittelpunkt der longitudinalen Mittellinie gesetzt wird.

## Revendications

1. Procédé de traitement de substrats (10) dans la formation de modules photovoltaïques (PV), les substrats ayant une pluralité de couches de film mince (18, 20, 22) déposées sur ceux-ci, ledit procédé comprenant :
la détermination du centre géométrique (24) du substrat ; et
la réalisation d'étapes de traitement ultérieur pour définir des cellules individuelles (32) sur le substrat en utilisant le centre géométrique du substrat comme point de référence de départ pour ces étapes de traitement, dans lequel les étapes de traitement ultérieur comprennent une inscription au laser d'un motif de lignes (30) dans les couches de film mince sur le substrat (10) pour définir les cellules individuelles (32), un emplacement pour un motif de lignes initial étant établi à une distance définie du centre géométrique (24) du substrat, et comprenant en outre la définition d'un axe longitudinal (28) du substrat à travers le centre géométrique du substrat et la définition du motif de lignes (30) à une perpendiculaire de l'axe longitudinal.

2. Procédé selon la revendication 1, comprenant en outre la réalisation d'étapes supplémentaires de traitement ultérieur pour définir une bordure d'isolement (36) sur le substrat (10) autour des cellules individuelles (30) en utilisant le centre géométrique (24) du substrat comme point de référence de départ pour ces étapes supplémentaires de traitement ultérieur.

3. Procédé selon la revendication 2, dans lequel les étapes supplémentaires de traitement ultérieur comprennent une inscription au laser d'une bordure d'isolement rectangulaire (36) qui définit les extrémités longitudinales des cellules individuelles (30) et une ligne externe de la première et la dernière des cellules individuelles sur le substrat (10), la bordure d'isolement rectangulaire (36) étant définie en plaçant le centre géométrique de la bordure d'isolement rectangulaire de manière à coïncider avec le centre géométrique du substrat.

4. Procédé selon la revendication 2 ou la revendication 3, comprenant en outre la réalisation d'étapes additionnelles de traitement ultérieur pour définir une zone de suppression de bord (38) vers l'extérieur de la bordure d'isolement (36) sur le substrat (10) en utilisant le centre géométrique (24) du substrat comme point de référence de départ pour ces étapes additionnelles de traitement ultérieur.

5. Procédé selon l'une quelconque des revendications 2 à 4, dans lequel les étapes de traitement ultérieur additionnelles comprennent la définition de la zone de suppression de bord (38) comme bordure rectangulaire autour de la bordure d'isolement (36) sur le substrat (10) en plaçant les côtés de la bordure rectangulaire à des distances définies par rapport au centre géométrique du substrat.

6. Procédé selon l'une quelconque des revendications 2 à 5, comprenant en outre la définition d'une zone de suppression de bord (38) vers l'extérieur de la bordure d'isolement (36), la zone de suppression de bord ayant des dimensions qui sont mesurées vers l'intérieur depuis les bords du substrat.

7. Procédé selon l'une quelconque des revendications précédentes, dans lequel le centre géométrique (24) du substrat (10) est déterminé par :
la définition d'une première paire de points (26) sur les côtés longitudinaux (12) du substrat situés en retrait à une distance définie par rapport à une première extrémité longitudinale (14) du substrat, ou d'une seconde paire de points (26) sur les côtés longitudinaux (12) du substrat situés en retrait à une distance définie depuis une seconde extrémité longitudinale (14) du substrat (10) ; et
la détermination du centre d'une ligne tracée entre les points dans chaque paire de points respective, et le traçage d'une ligne longitudinale entre les centres pour établir une ligne centrale longitudinale (28) du substrat et le prolongement de la ligne centrale longitudinale jusqu'aux extrémités du substrat, la ligne centrale géométrique (24) étant établie au point central de la ligne centrale longitudinale.
